# EUROPEAN PATENT APPLICATION

(11) **EP 4 679 713 A1**
(43) Date of publication of application: **14.01.2026**
(21) Application number: 25187100.0
(22) Date of filing: 03.07.2025
(51) Int. Cl.: H03K 17/0814, H03K 17/10, H03K 17/687, H03K 17/06, H03K 17/14

(54) **CASCODE SWITCHING CIRCUIT**

(30) Priority: 11.07.2024 US 202463669729 P; 20.06.2025 US 202519244531
(71) Applicant: Semiconductor Components Industries, LLC, Scottsdale, AZ 85250 (US)
(72) Inventor: LI, Xueqing, East Brunswick, NJ 08816 (US); BHALLA, Anup, Princeton Junction, NJ 08850 (US); ZHU, Ke, Princeton, NJ 08540 (US)
(74) Representative: Manitz Finsterwald Patent- und Rechtsanwaltspartnerschaft mbB

(57) **Abstract**

A cascode switching circuit is disclosed. The cascode switching circuit includes a cascode device comprising a JFET and a MOSFET coupled in a cascode topology. The cascode switching circuit further includes a gate driver having a gate-driver input configured to receive a switching input signal and a gate-driver output coupled to a gate of the MOSFET and configured to switch the MOSFET between a MOSFET ON-state and a MOSFET OFF-state based on the switching input signal. In addition, the cascode switching circuit includes a current source coupled between the gate-driver output and the gate of the JFET and configured to forward bias a gate-source junction of the JFET when the cascode device is in an ON-state.

## Description

This application claims the benefit of U.S. Provisional Patent Application No. 63/669,729, filed July 11, 2024, which is hereby incorporated by reference herein in its entirety.

### FIELD OF THE DISCLOSURE

The technology of the disclosure relates generally to power electronics, and specifically to a cascode switch circuit and gate drive methods for driving cascode-configured switches.

### BACKGROUND

Power electronics may be used to control the conversion and distribution of electric power. For example, switching power converters may be used to create a direct current ("DC") voltage from an alternating current ("AC") voltage by switching current through a magnetic element such as an inductor. Conversely, inverters can be used to convert a DC voltage to an AC voltage. In these and other forms of power electronics, power switches may be used to control the conversion and flow of power through the power-conversion system and to the electronic circuitry to be powered by the device. Specifically, power conversion may be performed by switching power converters or invertors that operate by toggling one or more respective switches between an ON-state (also referred to as a closed state or a conductive state) and an OFF-state (also referred to as an open state or a non-conductive state). Power switches may also be used in various solid-state protection applications to quickly isolate and protect electrical circuits and systems from faults like overcurrent conditions, overvoltage conditions, and/or short-circuit conditions.

Cascode switches may be used as the power switch in power conversion systems and/or solid-state protection applications to drive high currents and to withstand large voltages. When used in such power applications, it may be desirable for the one or more cascode switches to have a low ON-state resistance, thereby limiting unwanted power loss and heat generation. Inventors of embodiments of the present disclosure have recognized that lowering the ON-state resistance of a cascode switch for a given application typically comes at the expense of larger die size and increased cost. The inventors of embodiments of the present disclosure have also recognized that providing a higher saturation current (and thus a higher surge current capability) for a given application also typically comes at the expense of larger die size and increased cost. Embodiments of the present disclosure may address one or more of these challenges.

### SUMMARY

Aspects disclosed in the detailed description are related to a power switching device operable to reduce ON-state resistance and to increase saturation current (and thus increase surge current capability).

According to one example, a cascode switching circuit includes a cascode device comprising a JFET and a MOSFET coupled in a cascode topology; a gate driver having a gate-driver input configured to receive a switching input signal and a gate-driver output coupled to a gate of the MOSFET and configured to switch the MOSFET between a MOSFET ON-state and a MOSFET OFF-state based on the switching input signal; and a current source coupled between the gate-driver output and the gate of the JFET and configured to forward bias a gate-source junction of the JFET when the cascode device is in an ON-state. In some examples, the cascode switching circuit further includes a voltage clamp coupled to the gate of the JFET and configured to prevent a gate voltage of the JFET from exceeding a clamp threshold. In some examples, the voltage clamp comprises a Zener diode. In the same or different examples, the cascode switching circuit further includes a resistor coupled in series between the gate-driver output and the gate of the MOSFET. In the same or different examples, the cascode switching circuit further includes capacitor coupled in parallel to the current source. In the same or different examples, the cascode switching circuit further includes a junction resistor coupled between the current source and the gate of the JFET. In the same or different examples, the current source comprises a resistor. In the same or different examples, the MOSFET is an NMOS transistor. In the same or different examples, the MOSFET is a silicon MOSFET, and the JFET is a silicon carbide JFET. In the same or different examples, the cascode switching circuit further includes a junction temperature sensor coupled across the gate of the JFET and a source of the JFET and configured to output a sensor voltage signal that varies based on the temperature of the JFET.

According to another example, a cascode switching circuit includes a cascode device comprising a JFET and a MOSFET coupled in a cascode topology; a gate driver having a gate-driver input configured to receive a switching input signal and a gate-driver output coupled to a gate of the MOSFET and configured to switch the MOSFET between a MOSFET ON-state and a MOSFET OFF-state based on the switching input signal; and a current source coupled between a power supply and the gate of the JFET and configured to forward bias a gate-source junction of the JFET when the cascode device is in an ON-state. In some examples, the cascode switching circuit further includes a voltage clamp coupled to the gate of the JFET and configured to prevent a gate voltage of the JFET from exceeding a clamp threshold. In some examples, the voltage clamp comprises a Zener diode. In the same or different examples, the cascode switching circuit further includes a resistor coupled in series between the gate-driver output and the gate of the MOSFET. In the same or different examples, the current source comprises a resistor. In the same or different examples, the MOSFET is an NMOS transistor. In the same or different examples, the MOSFET is a silicon MOSFET, and the JFET is a silicon carbide JFET. In the same or different examples, the cascode switching circuit further includes a junction temperature sensor coupled across the gate of the JFET and a source of the JFET and configured to output a sensor voltage signal that varies based on the temperature of the JFET.

Another example provides a method for operating a cascode device including a JFET and a MOSFET coupled in a cascode topology, the method including receiving a switching input signal, switching the MOSFET between a MOSFET ON-state and a MOSFET OFF-state based on the switching input signal, and forward biasing a gate-source junction of the JFET with a current source when the cascode device is in an ON-state. In some examples, the method further includes providing a pulse current to a gate of the JFET with a capacitor coupled in parallel to the current source and in response to the switching input signal. In the same or different examples, the method further includes controlling a charge time and a discharge time of the gate of the JFET with a resistor coupled in series between the capacitor and the gate of the JFET. In the same or different examples, the method further includes monitoring a junction temperature of the JFET based on a gate-to-source voltage of the JFET. In the same or different examples, the MOSFET is a silicon MOSFET, and the JFET is a silicon carbide JFET.

Those skilled in the art will appreciate the scope of the disclosure and realize additional aspects thereof after reading the following detailed description in association with the accompanying drawings.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic diagram of a gate drive circuit for a cascode device in accordance with embodiments of the present disclosure.
FIG. 2 illustrates a schematic diagram of a cascode switching circuit in accordance with embodiments of the present disclosure.
FIG. 3 illustrates a schematic diagram of a cascode switching circuit in accordance with embodiments of the present disclosure.
FIG. 4 illustrates a schematic diagram of a cascode switching circuit in accordance with embodiments of the present disclosure.
FIG. 5 illustrates a schematic diagram of a cascode switching circuit in accordance with embodiments of the present disclosure.
FIG. 6 illustrates a schematic diagram of a cascode switching circuit in accordance with embodiments of the present disclosure.
FIG. 7 illustrates a schematic diagram of a junction temperature sensor in accordance with embodiments of the present disclosure.
FIG. 8 illustrates a plot diagram showing gate-to-source voltage for a JFET versus junction temperature in accordance with embodiments of the present disclosure.
FIG. 9 illustrates a plot diagram showing ON-state current-voltage characteristics of a cascode device at different junction temperatures (T_{J}) and different JFET gate biases in accordance with embodiments of the present disclosure.
FIG. 10 illustrates a plot diagram showing a measured ON-state resistance of a cascode device at different junction temperatures (T_{J}) and different JFET gate biases in accordance with embodiments of the present disclosure.
FIG. 11 illustrates a plot diagram showing waveforms of the cascode switching circuit of FIG. 4 in accordance with embodiments of the present disclosure.
FIG. 12 illustrates a block diagram of an interconnected system of components for an electric vehicle in which embodiments of the cascode switching circuit of the present disclosure may be deployed.
FIG. 13 illustrates a method for operating a cascode device including a JFET and a MOSFET coupled in a cascode topology in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following description and in the claims, the terms "including" and "comprising" are used in an open-ended fashion, and thus should be interpreted to mean "including, but not limited to." Also, the term "couple" or "coupled" is intended to mean either an indirect or direct connection. Thus, if a first device couples to, or is coupled to, a second device, that connection between the first device and the second device may be through a direct connection or through an indirect connection via other elements and connections.

Further, although the terms "first," "second," and so forth may be used herein to describe various elements, these elements should not be limited by these terms. Terms such as "first" and "second" may be used merely to distinguish one element from another. For example, a first element could be termed a second element, and, similarly, a second element could be termed a first element, without departing from the scope of the present disclosure. Further, the identification of a "first" element, does not necessarily require the presence of a "second" element. As used herein, the term "and/or" includes any and all combinations of one or more of the associated listed items.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

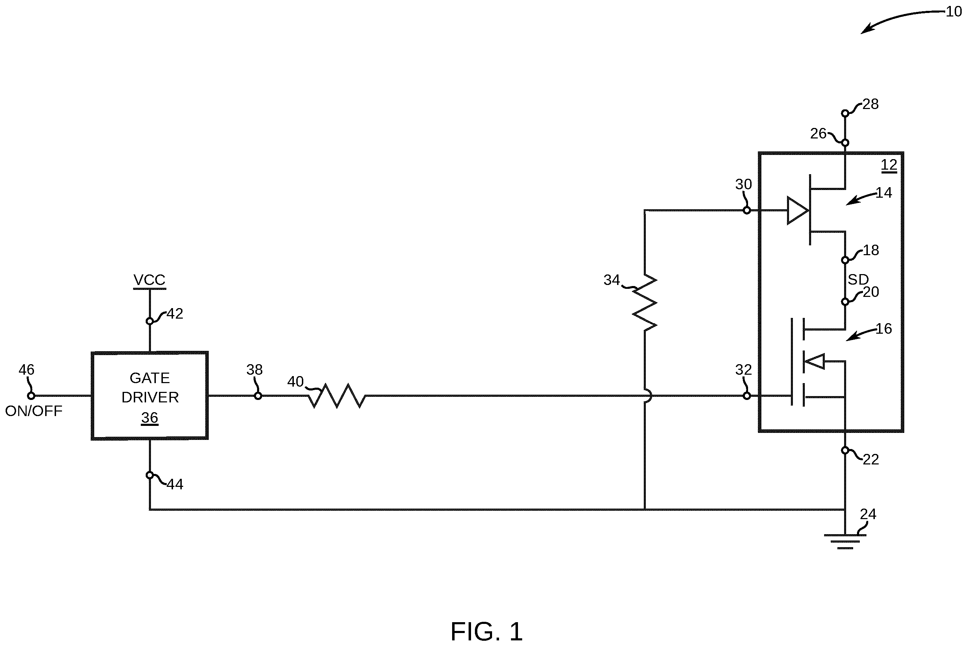

FIG. 1 illustrates a schematic diagram of gate drive circuit 10 for a cascode device 12 in accordance with embodiments of the present disclosure. As shown in FIG. 1, cascode device 12 may include junction field-effect transistor (JFET) 14 and a metal-oxide-semiconductor field-effect transistor (MOSFET) 16 coupled in a cascode topology.

JFET 14 may be a silicon carbide JFET formed for example on a silicon carbide substrate. JFET 14 may also be formed with any other semiconductor material, such as silicon (Si) or gallium nitride (GaN), suitable for use in power electronics for example. Further, JFET 14 may be a normally-on JFET. For the purposes of the present disclosure, a normally-on transistor (such as JFET 14) may also be referred to as a depletion-mode transistor. In some embodiments, JFET 14 may have a direct current (DC) voltage rating of, for example, 200 volts to 10,000 volts.

In some embodiments, MOSFET 16 may be an n-channel MOSFET (NMOS or NMOS transistor). Further, in some embodiments, MOSFET 16 may be a silicon MOSFET formed for example on a silicon substrate. MOSFET 16 may also be formed with any other semiconductor material, such as silicon carbide (SiC) or gallium nitride (GaN), suitable for use in power electronics for example. Further, MOSFET 16 may be a normally-off transistor. For the purposes of the present disclosure, a normally-off transistor (such as MOSFET 16) may also be referred to as an enhancement-mode transistor. MOSFET 16 may have a lower DC voltage rating than JFET 14. In some embodiments, MOSFET 16 may have a DC voltage rating of, for example, 10 volts to 70 volts.

As show in FIG. 1, a source terminal 18 of JFET 14 may be coupled to a drain terminal 20 of MOSFET 16 at an internal node SD of cascode device 12. Further, a source terminal 22 of MOSFET 16 may be coupled to a fixed voltage node 24, which is depicted as ground in FIG. 1. For the purposes of the present disclosure, the source terminal 22 of MOSFET 16 may also be referred to as the source terminal of cascode device 12 as a whole. In addition, a drain terminal 26 of the JFET 14 may be coupled to a load terminal 28 to which an external load (not shown) may be coupled. For the purposes of the present disclosure, the drain terminal 26 of JFET 14 may also be referred to as the drain terminal of cascode device 12 as a whole. A gate terminal 30 of JFET 14 and a gate terminal 32 of MOSFET 16 may be accessible externally to cascode device 12. As described in further detail below, gate terminal 30 of JFET 14 may be driven separately from gate terminal 32 of MOSFET 16 by gate drive circuit 10.

As shown in FIG. 1, the gate terminal 30 of JFET 14 may be coupled through resistor 34 to fixed voltage node 24. The resistance value of the resistor 34 may be, for example, in a range from 0 ohms to 100 ohms. Further, gate driver 36 may have a gate-driver output 38 that may be coupled through resistor 40 to the gate terminal 32 of the MOSFET 16 to control cascode device 12. Gate driver 36 may have a supply terminal 42 configured to receive a supply voltage VCC that is at a level (for example, 5, 8, 10, 12, 15, 20 volts of more) to power gate driver 36. Gate driver 36 may also have a grounding terminal 44 that may be coupled to the fixed voltage node 24.

Gate driver 36 may have a gate-driver input 46 that may be configured to receive a switching input signal that alternates between an ON signal (such as a logic-high signal) and an OFF signal (such as a logic-low signal). Gate driver 36 may be configured to respond to the ON signal by generating an ON-state voltage level at the gate-driver output 38 to turn on MOSFET 16 to effectively couple the load terminal 28 to the fixed voltage node 24. Gate driver 36 may be further configured to respond to the OFF signal by generating an off-state voltage level at the gate-driver output 38 to turn off MOSFET 16 to effectively decouple the load terminal 28 from the fixed voltage node 24.

In the ON-state of cascode device 12, both JFET 14 and MOSFET 16 will be in the on-state. A drain voltage (VSD_S) of the MOSFET 16 is positive and is equal to the product of the current flowing through cascode device 12 and the ON-state resistance of MOSFET 16. The drain voltage VSD_S may be relatively small due to the relatively small ON-state resistance of MOSFET 16 (for example, 10milliohms, 5 milliohms, 2 milliohms, or less). A JFET gate voltage VJG_S between the gate terminal 30 of the JFET 14 and the source terminal 22 of the MOSFET 16 may be near zero because there is no current flowing through the resistor 34 during on-state. Therefore, the JFET gate bias (VJG_SD) between the gate terminal 30 of the JFET 14 and the source terminal 18 of the JFET is VJG_SD = VJG_S - VSD_S = -VSD_S, indicating that a gate-source junction of the JFET 14 may be slightly reverse-biased in on-state.

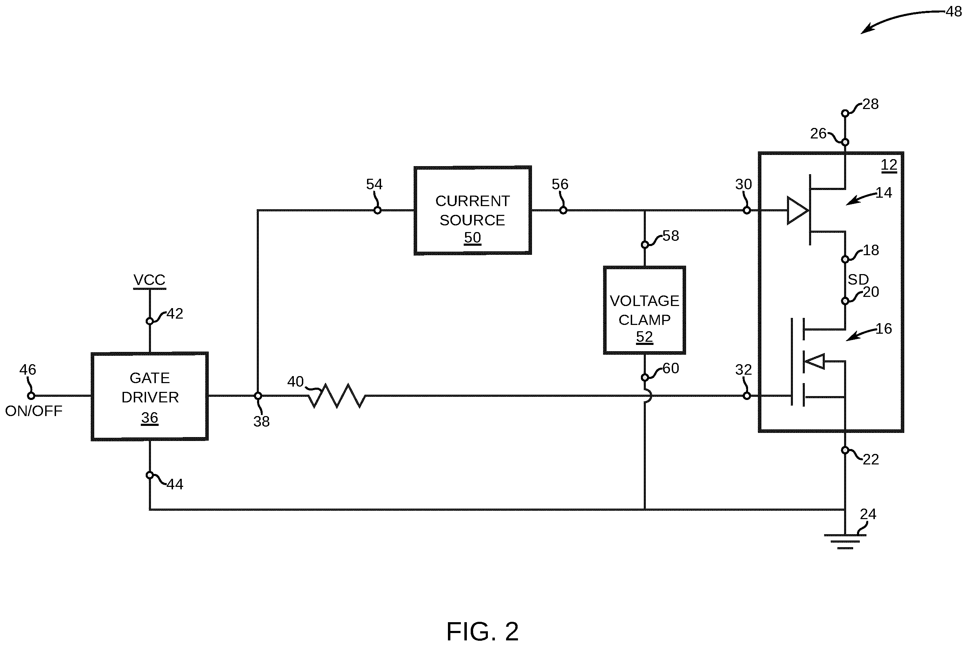

FIG. 2 illustrates a schematic diagram of a cascode switching circuit 48 in accordance with embodiments of the present disclosure. As shown in FIG. 2, cascode switching circuit 48 may comprise cascode device 12 including JFET 14 and MOSFET 16 coupled in a cascode topology. Cascode switching circuit 48 may also include gate driver 36, resistor 40, current source 50, and voltage clamp 52, which as described in further detail below may be configured to collectively drive JFET 14 and MOSFET 16.

As described above with reference to FIG. 1, gate driver 36 may have a gate-driver input 46 configured to receive a switching input signal and a gate-driver output 38 coupled to a gate of MOSFET 16 and configured to switch MOSFET 16 between a MOSFET ON-state and a MOSFET OFF-state based on the switching input signal. Further, as shown in FIG. 2, cascode switching circuit 48 may further include resistor 40 coupled in series between gate-driver output 38 and the gate of MOSFET 16. The resistance value of resistor 40 may thus be selected to control the switching speed of MOSFET 16 during transitions from a MOSFET ON-state to a MOSFET OFF-state, or vice versa from a MOSFET OFF-state to a MOSFET ON-state.

Current source 50 may be coupled between the gate-driver output 38 and the gate of JFET 14 and configured to forward bias a gate-source junction of JFET 14 when cascode device 12 is in an ON-state. Specifically, current source 50 may be coupled in series between the gate-driver output 38 of gate driver 36 and the gate terminal 30 of JFET 14.

Current source 50 may have a current source input terminal 54 and a current source output terminal 56. A voltage drop between the current source input terminal 54 and the current source output terminal 56 during normal operation may be, for example, in a range from 0.5 volts to 40 volts. The output current of the current source 50 may typically be constant, and may be in a range, for example, from 0.01 mA to 100 mA. In some embodiments, current source 50 may be implemented with a resistor, a current regulator, or combinations thereof.

Voltage clamp 52 may be coupled to the gate of JFET 14 and configured to prevent a gate voltage of JFET 14 from exceeding a clamp threshold. For example, voltage clamp 52 may be coupled between the gate terminal 30 of JFET 14 and the source terminal 22 of MOSFET 16. In some embodiments, voltage clamp 52 may have electrical characteristics similar to that of a Zener diode, where a first clamp terminal 58 operates similar to a cathode of the Zener diode and a second clamp terminal 60 operates similar to an anode of the Zener diode. Accordingly, a clamp voltage across the voltage clamp 52 may be similar to the reverse-breakdown voltage of a Zener diode. The clamp voltage of voltage clamp 52 may be greater than the normal operating JFET gate voltage VJG_S between the gate terminal 30 of JFET 14 and the source terminal 22 of MOSFET 16. The value of the clamp voltage may be within a range, for example, from 3 volts to 10 volts. The voltage clamp 52 may be formed with a Zener diode, or an avalanche diode, or an avalanche-rated silicon MOSFET, or any other voltage clamping circuits suitable to clamp the voltage between first clamp terminal 58 and second clamp terminal 60.

To drive cascode device 12 in an ON-state, gate driver 36 may output a high-level voltage that may be in a range from +5 volts to +25 volts, for example. The high-level voltage provided to the gate terminal 32 of MOSFET 16 may drive MOSFET 16 in an ON-state. Further, under such conditions, current source 50 may provide a current at current source output terminal 56 sufficient to bias the gate terminal 30 of JFET 14 at a positive voltage holding JFET 14 in an ON-state. For example, a JFET gate voltage VJG_S between the gate terminal 30 of JFET 14 and the source terminal 22 of MOSFET 16 may be in a range, for example, from 1 volt to 3 volts, which may be smaller than the clamp voltage of voltage clamp 52. Accordingly, voltage clamp 52 may normally operate in a blocking mode with a negligible leakage current during the ON-state of cascode device 12, and the output current of current source 50 may flow into the gate terminal 30 of JFET 14 to forward-bias the gate-source junction of JFET 14.

To drive cascode device 12 in an OFF-state, gate driver 36 may output a low-level voltage that may be in a range from 0 volts to -10 volts, for example. The low-level voltage provided to the gate terminal 32 of MOSFET 16 may drive MOSFET 16 in an OFF-state. Further, under such conditions, the gate-source junction of JFET 14 may be reverse-biased (and may thus conduct a negligible leakage current). In embodiments where the output voltage of gate driver 36 is 0 volts, the JFET gate voltage VJG_S between the gate terminal 30 of JFET 14 and source terminal 22 of MOSFET 16 may be approximately 0 volts because there may be no current flowing through current source 50. In other embodiments where the output voltage of the gate driver 36 is negative (for example -10 volts), a small reverse current may flow through voltage clamp 52 from the second clamp terminal 60 to the first clamp terminal 58, then through current source 50 from the current source output terminal 56 to the current source input terminal 54, and to the gate-driver output 38 of gate driver 36. The reverse current may be limited (for example in the mA range) by the resistance of current source 50. Accordingly, the JFET gate voltage VJG_S between the gate terminal 30 of JFET 14 and the source terminal 22 of MOSFET 16 may equal 0 volts minus VTAtoTC, where VTAtoTC is the forward voltage drop across the voltage clamp 52. The typical value of VTAtoTC may be in a range from 0.5 volts to 2.0 volts, for example. Thus, the JFET gate voltage VJG_S between the gate terminal 30 of JFET 14 and the source terminal 18 of JFET 14 may be in a range from 0 volts to -2 volts depending on the output voltage level of the gate driver 36 and the forward voltage drop of the voltage clamp 52.

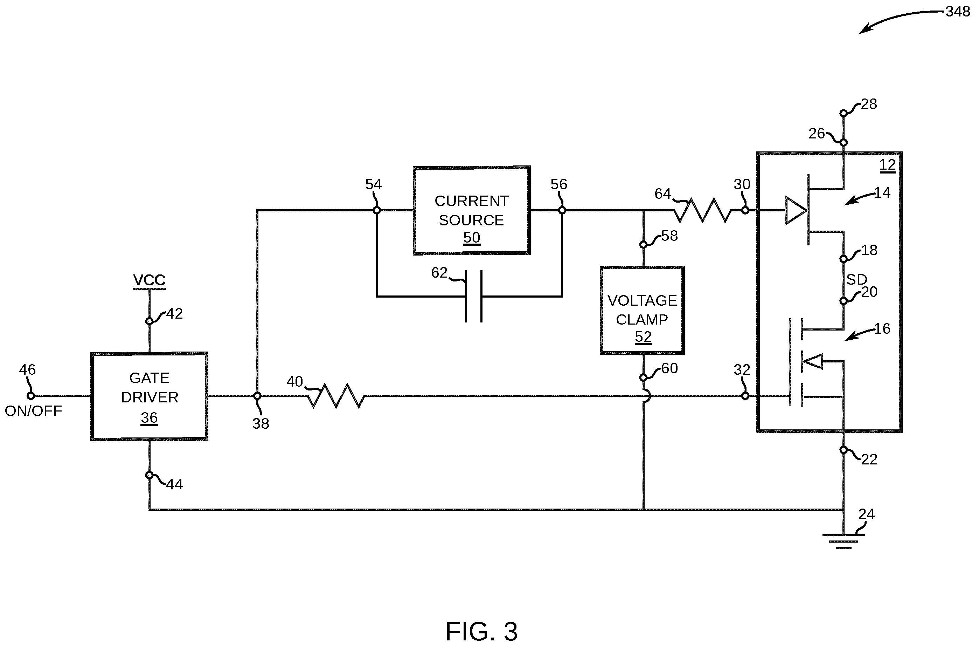

FIG. 3 illustrates a schematic diagram of cascode switching circuit 348 in accordance with embodiments of the present disclosure. As shown in FIG. 3, cascode switching circuit 348 may include similar components as cascode switching circuit 48 described above with reference to FIG. 2. For example, cascode switching circuit 348 may include gate driver 36, resistor 40, current source 50, voltage clamp 52, and cascode device 12, which may operate in a similar manner as described above with reference to FIG. 2. In addition, cascode switching circuit 348 may also include capacitor 62 and junction resistor 64. Capacitor 62 may be coupled in parallel to current source 50. Further, junction resistor 64 may be coupled between current source 50 and the gate of JFET 14. Thus, as described in further detail below, capacitor 62 and junction resistor 64 may control the switching transition time of cascode device 12.

When switching cascode device 12 from an OFF-state to an ON-state, or conversely from an ON-state to an OFF-state, a large pulse current may be provided by capacitor 62 to quickly charge or discharge the gate input capacitance of JFET 14. The large pulse current may be up to or greater than 20 amps, for example, when cascode device 12 is a module consisting multiple JFET chips in parallel. As described above, current source 50 may be configured such that the output current of current source 50 is small (for example in the mA range). Accordingly, current source 50 may have little effect on charging and discharging the gate input capacitance of JFET 14, and thus on the switching speed of cascode device 12. In the absence of capacitor 62, the large pulse current must otherwise flow through voltage clamp 52, thus requiting voltage clamp 52 to have a high surge-current capability. To reduce the required surge current capability of voltage clamp 52, capacitor 62 may be coupled in parallel with current source 50. Thus, when gate-driver output 38 of gate driver 36 transitions from low to high (to turn on cascode device 12) or transitions from high to low (to turn off cascode device 12), capacitor 62 may provide an AC coupling that provides a large charging current or discharging current to the gate of JFET 14.

In some embodiments, the switching speed of the cascode device 12 may be further controlled with junction resistor 64, which may be coupled in series between the gate terminal 30 of JFET 14 and the current source output terminal 56. In some embodiments (such as the embodiment shown in FIG. 3), junction resistor 64 may be implemented by a single resistor. In other embodiments, junction resistor 64 may be formed by resistive circuitry that may include, for example, a network of resistors and/or diodes. The resistance of junction resistor 64 may, together with the gate capacitance of JFET 14, provide an RC-delay that may be tuned to achieve the desired rise-times and fall-times of the gate voltage of JFET 14 during transitions from the OFF-state to the ON-state and conversely from the ON-state to the OFF-state.

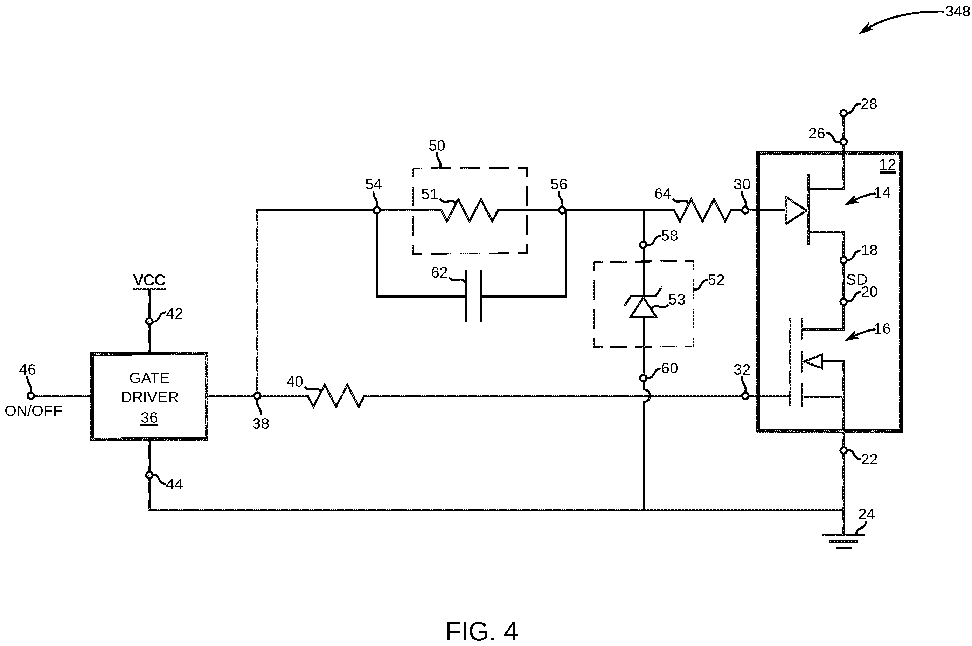

FIG. 4 illustrates a schematic diagram of a cascode switching circuit 348 in accordance with embodiments of the present disclosure. As shown in FIG. 4, current source 50 may in some embodiments be implemented with resistor 51. Resistor 51 may have a resistance value in the kΩ range for example. Thus, as described above, current source 50 may provide an output current in the mA range, for example, from 0.01 mA to 100 mA depending on the voltage of the gate-driver output 38 of gate driver 36. Further, voltage clamp 52 may in some embodiments be implemented with Zener diode 53. As described above, voltage clamp 52 may be configured with a clamp voltage in a range, for example, from 3 volts to 10 volts. Zener diode 53 may thus be configured with a reverse breakdown voltage equal to the desired clamp voltage (for example in a range from 3 volts to 10 volts).

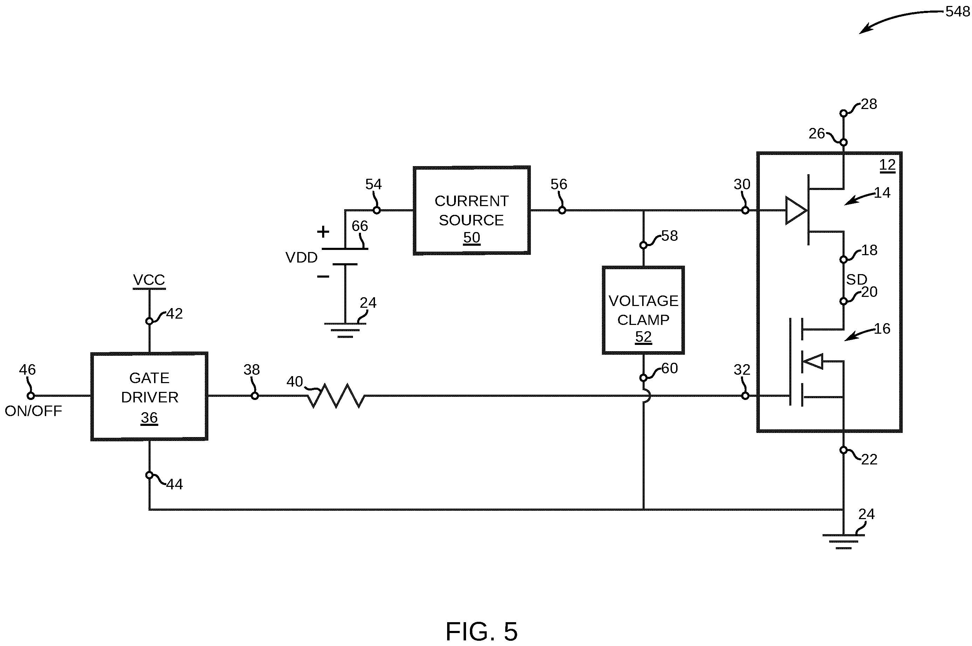

FIG. 5 illustrates a schematic diagram of cascode switching circuit 548 in accordance with embodiments of the present disclosure. As shown in FIG. 5, cascode switching circuit 548 may include similar components as cascode switching circuit 48 described above with reference to FIG. 2. For example, cascode switching circuit 548 may include gate driver 36, resistor 40, current source 50, voltage clamp 52, and cascode device 12, which may operate in a similar manner as described above with reference to FIG. 2 unless otherwise described below.

As shown in FIG. 5, current source 50 may be coupled between power supply 66 and the gate of JFET 14, and may be configured to forward bias a gate-source junction of JFET 14 when cascode device 12 is in an ON-state. For example, current source input terminal 54 of current source 50 may be coupled to a power supply 66 having a voltage VDD sufficient to drive current into the gate terminal 30 of the JFET 14. In some embodiments, VDD may be for example, 3 volts, 5 volts, 10 volts, 20 volts, or more. When MOSFET 16 (and cascode device 12 as a whole) is driven in an ON-state, the output current of current source 50 may flow into the gate terminal 30 of JFET 14 to forward-bias the JFET gate-source junction. When MOSFET 16 (and cascode device 12 as a whole) is driven in an OFF-state, the gate-source junction of JFET 14 may be reverse-biased with a negligible leakage current, such that the output current of current source 50 may flow into the voltage clamp 52 and drive the voltage clamp 52 into voltage clamp mode. Therefore, during the OFF-state of MOSFET 16 (and cascode device 12 as a whole), the JFET gate voltage VJG_S may be equal to the clamp voltage of the voltage clamp 52.

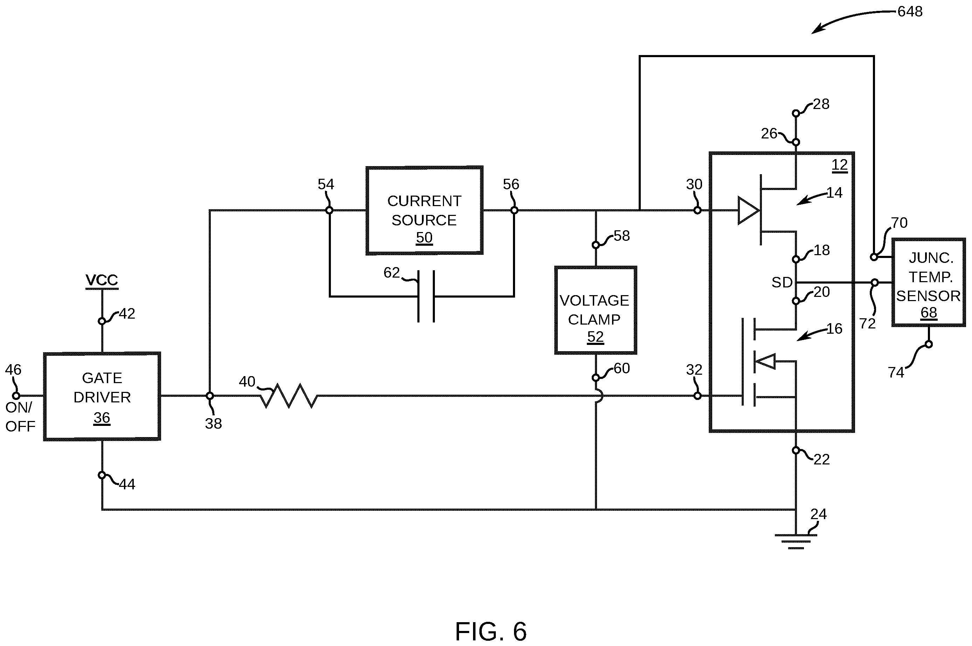

The gate-source junction of JFET 14 is a PN-junction. Thus, the gate-source junction of JFET 14 may be forward-biased with the output current of current source 50 during the ON-state. Typically, the output current of the current source 50 is constant or near-constant during operation. Thus, as described in further detail below with reference to FIG. 6, the gate-source voltage of JFET 14 may be used as a temperature-sensing parameter to measure the junction temperature of JFET 14 during the ON-state.

FIG. 6 illustrates a schematic diagram of cascode switching circuit 648 in accordance with embodiments of the present disclosure. As shown in FIG. 6, cascode switching circuit 648 may include similar components as cascode switching circuit 348 described above with reference to FIG. 3. For example, cascode switching circuit 648 may include gate driver 36, resistor 40, current source 50, voltage clamp 52, capacitor 62, junction resistor 64, and cascode device 12, which may operate in a similar manner as described above with reference to FIG. 3 (and with reference to FIG. 2) unless otherwise described below.

As shown in FIG. 6, cascode switching circuit 648 may also include junction temperature sensor 68. In some embodiments, junction temperature sensor 68 may be coupled across the gate of JFET 14 and the source of JFET 14 and configured to output a sensor voltage signal that varies based on the temperature of JFET 14. For example, junction temperature sensor 68 may have a gate voltage input terminal 70 coupled to the gate terminal 30 of JFET 14, and may have a source voltage input terminal 72 coupled to the source terminal 18 of JFET 14. Junction temperature sensor 68 may thus measure the gate-to-source voltage of JFET 14 during the ON-state of cascode device 12. The gate-to-source voltage of a JFET (such as JFET 14) may typically vary across temperature by approximately -2 mV/°C. Junction temperature sensor 68 may thus convert the gate-to-source voltage of JFET 14 to a sensor voltage signal that is substantially proportional (or inversely proportional) to the junction temperature of JFET 14. A temperature sensor output terminal 74 may be provided externally from the junction temperature sensor 68 to output the sensor voltage signal to external protection circuitry (not shown) that may respond to the sensor voltage signal to turn off the cascode device 12 in case of an over-temperature condition.

Although junction temperature sensor 68 is depicted in FIG. 6 as part of cascode switching circuit 648, junction temperature sensor 68 may likewise be coupled across the gate and source of JFET 14 to monitor the temperature of JFET 14 in any of cascode switching circuit 48 (FIG. 2), cascode switching circuit 348 (FIG. 3 and FIG. 4), and cascode switching circuit 548 (FIG. 5).

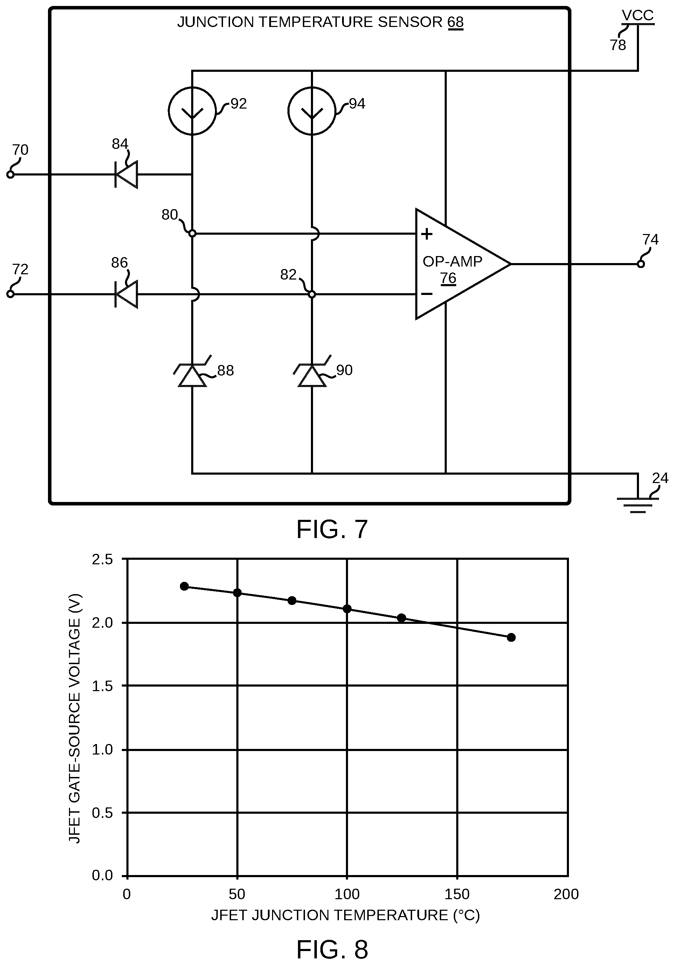

FIG. 7 illustrates a schematic diagram of junction temperature sensor 68 in accordance with embodiments of the present disclosure. Although a particular circuit configuration is shown in FIG. 7 for illustration purposes, junction temperature sensor 68 may be implemented with any circuit configuration suitable to provide a sensor voltage signal proportional (or inversely proportional) to temperature.

As shown in FIG. 7, junction temperature sensor 68 may have an operational amplifier 76 coupled between a supply rail 78 and the fixed voltage node 24 to receive power during operation. The supply rail 78 may be powered with the supply voltage VCC. Operational amplifier 76 may have a non-inverting input terminal 80 and an inverting input terminal 82. A first isolation diode 84 may have a cathode coupled to the gate voltage input terminal 70 and an anode coupled to the non-inverting input terminal 80 of operational amplifier 76. A second isolation diode 86 may have a cathode coupled to the source voltage input terminal 72 and an anode coupled to the inverting input terminal 82 of operational amplifier 76. The first isolation diode 84 and the second isolation diode 86 may provide a high isolation impedance when cascode device 12 (shown in FIG. 6) is in an OFF-state.

Junction temperature sensor 68 may further include a first protective voltage clamp 88 that may be coupled between the non-inverting input terminal 80 and the fixed voltage node 24. A second protective voltage clamp 90 may be coupled between the inverting input terminal 82 and the fixed voltage node 24. In the exemplary embodiment of FIG. 7, both the first protective voltage clamp 88 and the second protective voltage clamp 90 may be implemented by Zener diodes that clamp the non-inverting input terminal 80 and the inverting input terminal 82 to a safe voltage range (for example between 5 volts and 8 volts).

A first sensor current source 92 may be coupled between the supply rail 78 and the non-inverting input terminal 80. Further, a second sensor current source 94 may be coupled between the supply rail 78 and the inverting input terminal 82. The first sensor current source 92 and the second sensor current source 94 may be configured for measuring the voltages between the gate terminal 30 of the JFET 14 and the source terminal 18 of JFET 14 (shown in FIG. 6). In some embodiments, the current values for the first sensor current source 92 and the second sensor current source 94 may be in a range between, for example, 0.1 mA and 10 mA. Operational amplifier 76 may be configured to convert the voltages between the gate terminal 30 of the JFET 14 and the source terminal 18 of JFET 14 (shown in FIG. 6) to a ground-referenced temperature-related sensor output voltage that may be provided to external circuitry (not shown) coupled to the temperature sensor output terminal 74.

As described above, the gate-to-source voltage of a JFET, such as JFET 14, may typically be approximately -2 mV/°C. Nonetheless, to most accurately relate the sensor voltage signal at the output of junction temperature sensor 68 to a JFET junction temperature, the precise gate-to-source voltage of a specific JFET design (such as the design for JFET 14) may be measured by an experiment on an instance of that JFET design. For example, the precise gate-to-source voltage of a specific JFET design (such as the design for JFET 14) as a function of the junction temperature may be measured as shown in FIG. 8.

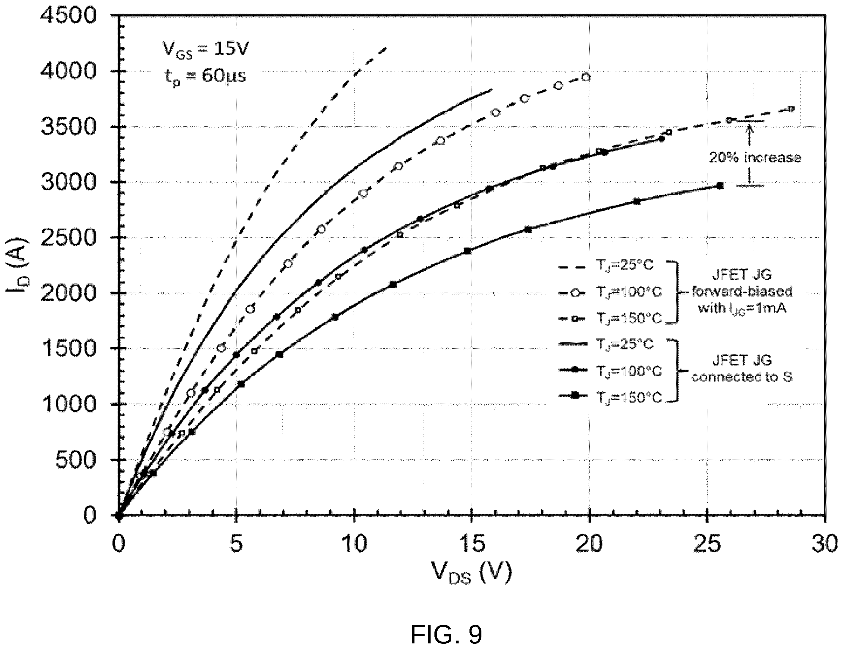

FIG. 9 illustrates a plot diagram showing ON-state current-voltage characteristics of a cascode device at different junction temperatures (T_{J}) and different JFET gate biases in accordance with embodiments of the present disclosure. Specifically, FIG. 9 illustrates the ON-state current-voltage characteristics of a cascode device (such as cascode device 12) with the MOSFET (such as MOSFET 16) driven with a gate-to-source voltage (V_{GS}) of 15 volts, a pulse settling time (tₚ) of 60 µs, and the gate of the JFET (JG) either (i) forward biased with a forward-bias current (I_{JG}) of 1 mA, or (ii) coupled to the source terminal (S) of the cascode device. As shown in FIG. 9, forward biasing the gate of the JFET (JG) may provide for an increased drain current (I_{D}) for a given drain-to-source voltage (V_{DS}) of the cascode device. In some examples, forward biasing the gate of the JFET (JG) with a forward-bias current (L_{JG}) of 1 mA may provide for a 20% increase, for example, of the drain current (I_{D}) at a given drain-to-source voltage (V_{DS}) of the cascode device.

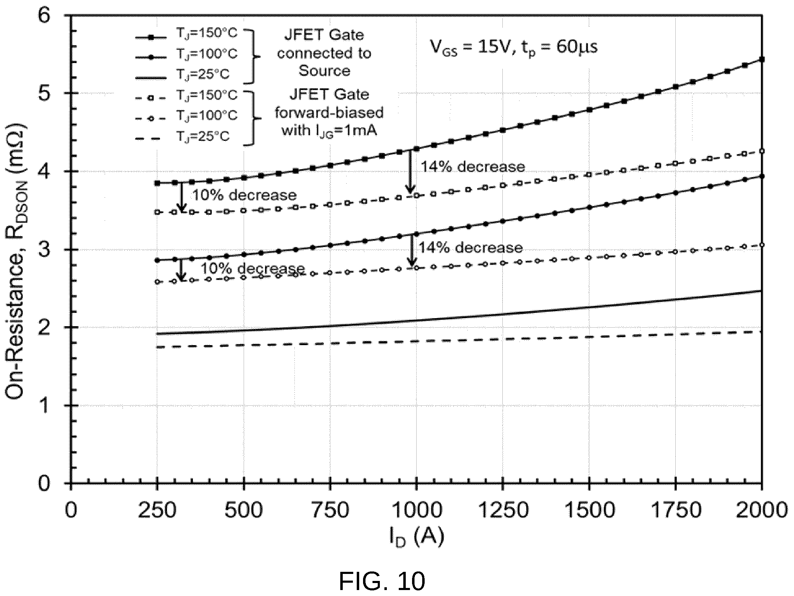

FIG. 10 illustrates a plot diagram showing a measured ON-state resistance of a cascode device at different junction temperatures (T_{J}) and different JFET gate biases in accordance with embodiments of the present disclosure. Specifically, FIG. 10 illustrates the ON-state resistance (R_{DSON}) of a cascode device (such as cascode device 12) with the MOSFET (such as MOSFET 16) driven with a gate-to-source voltage (V_{GS}) of 15 volts, a pulse settling time (tₚ) of 60 µs, and the gate of the JFET (JG) either (i) forward biased with a forward-bias current (I_{JG}) of 1 mA, or (ii) coupled to the source terminal (S) of the cascode device. In some examples, forward biasing the gate of the JFET (JG) with a forward-bias current (I_{JG}) of 1 mA may provide, for example, a 10% reduction of the ON-state resistance (R_{DSON}) when the drain current (I_{D}) is approximately 250 amps, a 14% reduction of the ON-state resistance (R_{DSON}) when the drain current (I_{D}) is approximately 1000 amps, and higher percentage reductions of the ON-state resistance (R_{DSON}) as the drain current (I_{D}) increase further beyond 1000 amps.

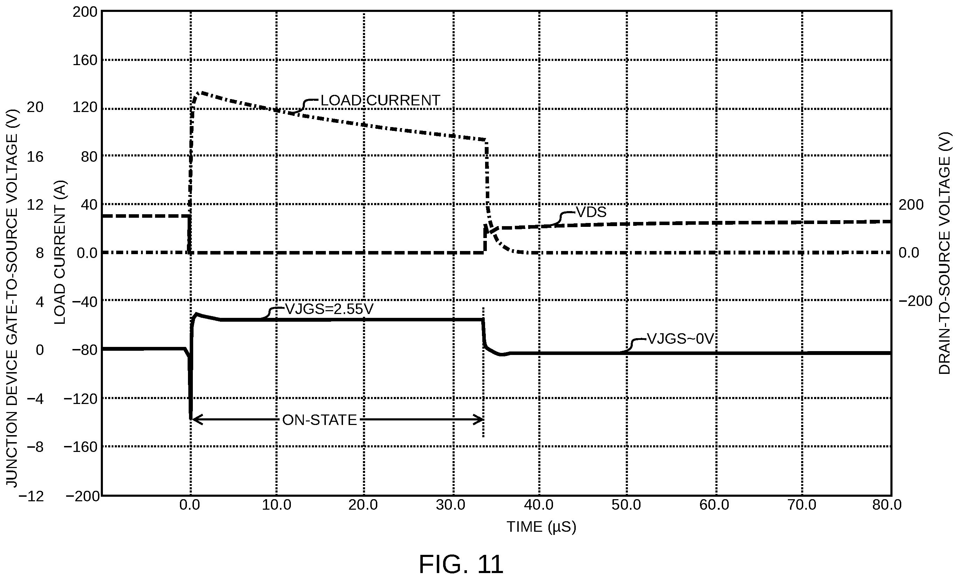

FIG. 11 illustrates a plot diagram showing waveforms of the cascode switching circuit of FIG. 4 in accordance with embodiments of the present disclosure. As shown in FIG. 11, the JFET gate voltage may transition from 0 volts during the OFF-state of cascode device 12 to approximately +2.55 volts during the ON-state of cascode device 12. Accordingly, the JFET gate-source junction may be forward biased during the ON-state, thereby reducing the ON-state resistance of JFET 14 (and of cascode device 12 as a whole).

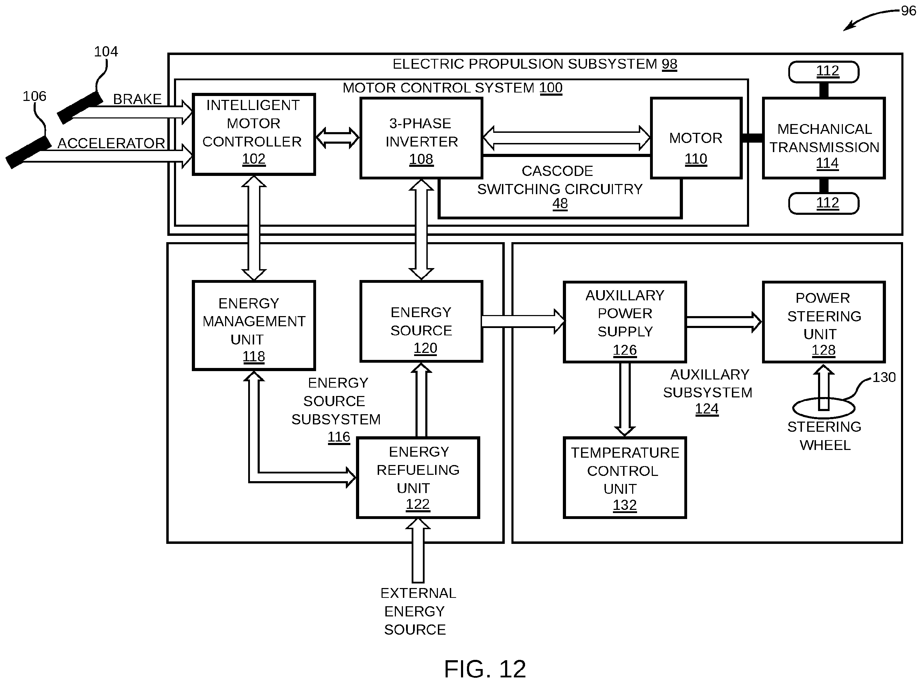

The various examples of cascode switching circuits disclosed herein, such as cascode switching circuits 48, 348, 548, and 648, may be employed in various applications, including, for example, electric vehicle applications. FIG. 12 illustrates a block diagram of an interconnected system of components for an electric vehicle 96 in which various embodiments of the cascode switching circuits described herein may be deployed.

As shown in FIG. 12, an electric propulsion subsystem 98 may include a motor control system 100. An intelligent motor controller 102 may be operatively coupled to a brake 104 and an accelerator 106 to receive inputs related to vehicle deceleration and acceleration, respectively. The intelligent motor controller 102 may process these inputs and regulate the flow of electrical energy to a 3-phase inverter 108, which may include a cascode switching circuit (such as any one of cascode switching circuits 48, 348, 548, and 648). The 3-phase inverter 108 may modulate the electrical power in response to signals from the intelligent motor controller 102 and supply this power to a motor 110. The cascode switching circuit 48 may be employed in a fusing process to protect the motor 110 in the event of an electrical fault. The motor 110 may convert the electrical energy into mechanical energy, which may then be transmitted to wheels 112 of the electric vehicle 96 through a mechanical transmission 114.

As shown in FIG. 12, an energy source subsystem may be adjacent to the electric propulsion subsystem 98. The energy source subsystem 116 may include an energy management unit 118 that may oversee the distribution and conservation of electrical energy within the electric vehicle 96. The energy management unit 118 may be coupled to an energy source 120, such as a rechargeable battery or fuel cell, which may provide the primary electrical energy for the electric vehicle 96. Additionally, an energy refueling unit 122 may be incorporated to facilitate the replenishment of the energy source 120 when depleted.

Furthermore, an auxiliary subsystem 124 may be incorporated to manage non-propulsion related functions. For example, an auxiliary power supply 126 may derive energy from the energy source 120 and channel the energy to various auxiliary components, including, for example, a power steering unit 128 that receives power to assist in the manipulation of a steering wheel 130, and a temperature control unit 132 that maintains the thermal conditions of the vehicle's systems.

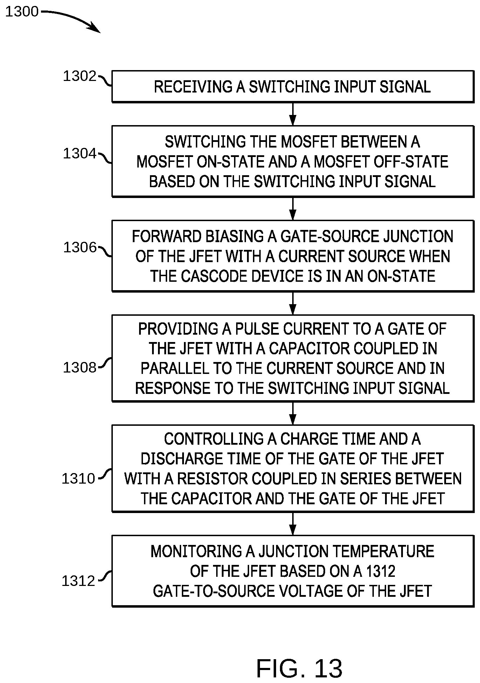

FIG. 13 illustrates a method 1300 for operating a cascode device including a JFET and a MOSFET coupled in a cascode topology in accordance with embodiments of the present disclosure. Method 1300 may be performed by any suitable mechanism, including, for example, cascode switching circuit 48, 348, 548, or 648, or any suitable combination thereof. Method 1300 may be performed with fewer or more steps than shown in FIG. 13. Moreover, the steps of method 1300 may be repeated, performed recursively, or performed in a different order than shown in FIG. 13.

At step 1302, method 1300 may include receiving a switching input signal. And at step 1304, method 1300 may include switching the MOSFET between a MOSFET ON-state and a MOSFET OFF-state based on the switching input signal. For example, as described above with reference to FIG. 2, gate driver 36 may have a gate-driver input 46 configured to receive a switching input signal and a gate-driver output 38 coupled to a gate of MOSFET 16 and configured to switch MOSFET 16 between a MOSFET ON-state and a MOSFET OFF-state based on the switching input signal.

At step 1306, method 1300 may include forward biasing a gate-source junction of the JFET with a current source when the cascode device is in an ON-state. For example, as described above with reference to FIG. 2, current source 50 may be coupled between the gate-driver output 38 and the gate of JFET 14 and may be configured to provide a current that forward biases the gate-source junction of JFET 14 when cascode device 12 is in an ON-state. In another example, described above with reference to FIG. 5, current source 50 may be coupled between power supply 66 and the gate of JFET 14, and may be configured to provide a current that forward biases the gate-source junction of JFET 14 when cascode device 12 is in an ON-state.

At step 1308, method 1300 may include providing a pulse current to a gate of the JFET with a capacitor coupled in parallel to the current source and in response to the switching input signal. For example, as described above with reference to FIG. 3, capacitor 62 may be coupled in parallel to current source 50. When transitioning the voltage level at gate-driver output 38 from an OFF-state to an ON-state, or conversely from an ON-state to an OFF-state, a large pulse current may be provided by capacitor 62 to quickly charge or discharge the gate input capacitance of JFET 14.

At step 1310, method 1300 may include controlling a charge time and a discharge time of the gate of the JFET with a resistor coupled in series between the capacitor and the gate of the JFET. For example, as described above with reference to FIG. 3, capacitor 62 may be coupled in parallel to current source 50, and junction resistor 64 may be coupled in series between current source 50 and the gate of JFET 14. The resistance of junction resistor 64 may, together with the gate capacitance of JFET 14, provide an RC-delay that may be tuned to achieve the desired rise-times and fall-times of the gate voltage of JFET 14 during transitions from the OFF-state to the ON-state and conversely from the ON-state to the OFF-state of cascode device 12.

At step 1312, method 1300 may include monitoring a junction temperature of the JFET based on a gate-to-source voltage of the JFET. For example, as described above with reference to FIG. 6, the gate-to-source voltage of a JFET (such as JFET 14) may typically vary across temperature. Accordingly, junction temperature sensor 68 may be coupled across the gate of JFET 14 and the source of JFET 14 and may be configured to output a sensor voltage signal that varies based on gate-to-source voltage of JFET 14 (which is a function of temperature).

Embodiments herein may include a method for operating a cascode device including a JFET and a MOSFET coupled in a cascode topology, the method comprising receiving a switching input signal, switching the MOSFET between a MOSFET ON-state and a MOSFET OFF-state based on the switching input signal, and forward biasing a gate-source junction of the JFET with a current source when the cascode device is in an ON-state. In some embodiments, the method further includes providing a pulse current to a gate of the JFET with a capacitor coupled in parallel to the current source and in response to the switching input signal. In the same or different embodiments, the method further includes controlling a charge time and a discharge time of the gate of the JFET with a resistor coupled in series between the capacitor and the gate of the JFET. In the same or different embodiments, the method further includes monitoring a junction temperature of the JFET based on a gate-to-source voltage of the JFET. In the same or different embodiments, the MOSFET is a silicon MOSFET, and the JFET is a silicon carbide JFET.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A cascode switching circuit comprising:
a cascode device comprising a JFET and a MOSFET coupled in a cascode topology;
a gate driver having a gate-driver input configured to receive a switching input signal and a gate-driver output coupled to a gate of the MOSFET and configured to switch the MOSFET between a MOSFET ON-state and a MOSFET OFF-state based on the switching input signal; and
a current source coupled between the gate-driver output and the gate of the JFET and configured to forward bias a gate-source junction of the JFET when the cascode device is in an ON-state.

2. The cascode switching circuit of claim 1, further comprising a voltage clamp coupled to the gate of the JFET and configured to prevent a gate voltage of the JFET from exceeding a clamp threshold.

3. The cascode switching circuit of claim 2, wherein the voltage clamp comprises a Zener diode.

4. The cascode switching circuit of claim 1, further comprising a resistor coupled in series between the gate-driver output and the gate of the MOSFET.

5. The cascode switching circuit of claim 1, further comprising a capacitor coupled in parallel to the current source.

6. The cascode switching circuit of claim 5, further comprising a junction resistor coupled between the current source and the gate of the JFET.

7. The cascode switching circuit of claim 1, wherein the current source comprises a resistor.

8. The cascode switching circuit of claim 1, wherein the MOSFET is an NMOS transistor.

9. The cascode switching circuit of claim 1, wherein:
the MOSFET is a silicon MOSFET; and
the JFET is a silicon carbide JFET.

10. The cascode switching circuit of claim 1, further comprising a junction temperature sensor coupled across the gate of the JFET and a source of the JFET and configured to output a sensor voltage signal that varies based on the temperature of the JFET.

11. A cascode switching circuit comprising:
a cascode device comprising a JFET and a MOSFET coupled in a cascode topology;
a gate driver having a gate-driver input configured to receive a switching input signal and a gate-driver output coupled to a gate of the MOSFET and configured to switch the MOSFET between a MOSFET ON-state and a MOSFET OFF-state based on the switching input signal; and
a current source coupled between a power supply and the gate of the JFET and configured to forward bias a gate-source junction of the JFET when the cascode device is in an ON-state.

12. The cascode switching circuit of claim 11, further comprising a voltage clamp coupled to the gate of the JFET and configured to prevent a gate voltage of the JFET from exceeding a clamp threshold.

13. The cascode switching circuit of claim 11, wherein the current source comprises a resistor.

14. The cascode switching circuit of claim 11, wherein:
the MOSFET is a silicon MOSFET; and
the JFET is a silicon carbide JFET.

15. The cascode switching circuit of claim 11, further comprising a junction temperature sensor coupled across the gate of the JFET and a source of the JFET and configured to output a sensor voltage signal that varies based on the temperature of the JFET.
